# EUROPÄISCHE PATENTSCHRIFT

(11) **EP 0 995 197 B1**
(45) Veröffentlichungstag und Bekanntmachung des Hinweises auf die Patenterteilung: **13.03.2002**
(21) Anmeldenummer: 98943695.1
(22) Anmeldetag: 14.07.1998
(51) Int. Cl.: G11C 16/04

(54) **HALBLEITERSPEICHER MIT NICHT-FLÜCHTIGEN ZWEI-TRANSISTOR-SPEICHERZELLEN**
SEMICONDUCTOR MEMORY WITH NON-VOLATILE DUAL TRANSISTOR MEMORY CELLS
MEMOIRE A SEMI-CONDUCTEURS A CELLULES BITRANSISTORS REMANENTES

(30) Priorität: 14.07.1997 DE 19730116
(43) Veröffentlichungstag der Anmeldung: 26.04.2000
(73) Patentinhaber: Infineon Technologies AG, 81669 München (DE)
(72) Erfinder: POCKRANDT, Wolfgang, D-85293 Reichertshausen (DE); SEDLAK, Holger, D-85658 Egmating (DE); VIEHMANN, Hans-Heinrich, D-81739 München (DE)
(74) Vertreter: Schweiger, Martin, Dipl.-Ing.
(86) Internationale Anmeldenummer: DE9801970
(87) Internationale Veröffentlichungsnummer: WO9904399

(56) Entgegenhaltungen:
- EP-A- 0 317 443
- EP-A- 0 750 313
- WO-A-96/34391

## Beschreibung

Die Erfindung betrifft einen Halbleiterspeicher mit wenigstens einer insbesondere nicht-flüchtigen Speicherzelle, die die folgenden Merkmale aufweist:
- Es ist ein N-Kanal-Auswahltransistor sowie ein N-Kanal Speichertransistor vorgesehen,
- der N-Kanal-Auswahltransistor weist einen Auswahl-Gateanschluß sowie zwei Auswahl-Kanalanschlüsse auf, wobei der Auswahl-Gateanschluß mit einer zu der Speicherzelle führenden Zeilenleitung in Verbindung steht,
- der N-Kanal Speichertransistor weist einen Speicher-Gateanschluß bzw. ein Kontrollgate sowie zwei Speicher-Kanalanschlüsse auf,
- ein zweiter Speicher-Kanalanschluß und ein erster Auswahl-Kanalanschluß stehen miteinander in Verbindung, wobei der andere Speicher-Kanalanschluß bzw. der andere Auswahl-Kanalanschluß mit einer zu der Speicherzelle führenden Spaltenleitung in Verbindung steht,
wobei der Halbleiterspeicher wenigstens einen Transfertransistor mit einem ersten und einen zweiten Transfer-Kanalanschluß aufweist, wobei der erste Transfer-Kanalanschluß mit dem Speicher-Gateanschluß in Verbindung steht.

Bei den gattungsgemäßen Halbleiterspeichern sind die einzelnen Transistoren in FET-Technologie auf einem Halbleitersubstrat ausgeführt. Dabei hat der Speichertransistor ein Floating Gate, so daß er durch Anlegen geeigneter Spannungen an die Kanalanschlüsse und an den Gateanschluß so programmiert werden, daß er dauerhaft bzw. nicht-flüchtig einen gewünschten Zustand annehmen kann.

Zum Auslesen der Speicherzelle sind ein Speicher-Kanalanschluß und ein Auswahl-Kanalanschluß miteinander verbunden, wobei der andere freie Speicher-Kanalanschluß bzw. der andere freie Auswahl-Kanalanschluß mit einer zu der Speicherzelle führenden Spaltenleitung verbunden ist. Dabei wird der Auswahltransitor so angesteuert, daß er durchschaltet. Wenn dann beim Anlegen einer Spannung an die entsprechende Spaltenleitung ein Strom fließt, dann wurde der Speichertransistor in einem vorhergehenden Schritt auf "leitend" programmiert bzw. geschrieben. Falls beim Anlegen dieser Spannung an die Spaltenleitung bei durchgeschalteten Auswahltransistor kein Strom fließt, dann wurde der Speichertransistor in einem vorhergehenden Schritt auf "nicht-leitend" programmiert bzw. gelöscht.

In der EP 0317 443 A1 ist eine Zwei-Transistoren-Speicherzelle offenbart, die einen Auswahltransistor und einen Floating-Gate-Transistor umfaßt. Das Gate des Floating-Gate-Transistors wird zur Ansteuerung mit einer besonderen Spannung beaufschlagt.

Bei den gattungsgemäßen Speichern ist besonders problematisch, daß die zum Programmieren notwendigen Spannungen mit einem hohen technologischen Aufwand erzeugt werden müssen. Darüber hinaus ergeben sich beim Programmieren einer Speicherzelle häufig Fehler in anderen Speicherzellen, die aktuell nicht für eine Programmierung angewählt sind.

Es ist daher Aufgabe der Erfindung, eine gattungsgemäße Speicherzelle sowie einen gattungsgemäßen Balbleiterspeicher bereitzustellen, der sich mit geringem technologischem Aufwand störungsfrei programmieren läßt.

Diese Aufgabe wird dadurch gelöst, daß der Transfertransistor als P-Kanal-Transfertransistor ausgeführt ist, wobei der zweite Transfer-Kanalanschluß nicht wie im Stand der Technik mit einer externen Kontrollgatespannung, sondern mit der zu der Speicherzelle führenden Zeilenleitung in Verbindung steht.

Die Erfindung beruht auf der Erkenntnis, daß bei den gattungsgemäßen Schaltungen ein Schwellenspannungsverlust im Transfertransistor überwunden werden muß, so daß höhere Transfer-Gatespannungen vorgesehen werden mußten. Dieses Problem kann dadurch gelöst werden, daß der Transfertransistor als Transistor mit einer reduzierten Schwellenspannung ausgeführt wird, was jedoch mit einem erhöhten technologischen Aufwand erkauft werden muß.

Bei der erfindungsgemäßen Ausbildung und Verschaltung des Transfertransistors braucht zur Programmierung des Speichertransistors keine Transfer-Gate-Schwellenspannung mehr überwunden werden, so daß eine zuverlässige Programmierung mit geringem technologischem Aufwand möglich ist.

Die Erfindung beruht weiterhin auf der Erkenntnis, daß die Kontrollgatespannung aufgrund der besonderen Verschaltung des Transfertransistors im Stand der Technik bei den aktuell nicht angesteuerten Speicherzellen in einem undefinierten Freilauf "floatet", was zu kapazitiven Überkopplungen der Programmierspannungen führen kann. Solche kapazitiven Überkopplungen kommen bei den Speicherzellen des erfindungsgemäßen Halbleiterspeichers nicht mehr vor, da sich beim Programmieren des erfindungsgemäßen Halbleiterspeichers jeder Speicher-Gateanschluß auf einem definierten Zustand befindet.

Der Transfer-Gateanschluß des Transfertransistors kann bei der erfindungsgemäßen Ausbildung mit einem auf Hochspannung gewandelten Logiksignal beaufschlagt werden. Sinnvollerweise wird hierfür ein Logiksignal verwendet, das auch den jeweiligen Programmierungszustand der Speicherzelle ansteuert. Durch das Ausführen des Transfertransistors als P-Kanal-Transfertransistor wird dabei das Vorsehen eines in der Herstellung aufwendigen Inverters zum Ansteuern des Transfer-Gateanschlusses vermieden, da ein P-Kanal-Transfertransistor dann sperrt, wenn das Gate angesteuert wird, und umgekehrt. Prinzipiell läßt sich der Transfertransistor mit einem solchen Inverter jedoch auch als N-Kanal-Transfertransistor ausbilden.

Mit der erfindungsgemäßen Anordnung kann die volle Programmierspannung ohne Verluste und ohne weitere besondere Maßnahmen über den Kanal des Transfertransistors auf die Speicher-Gateanschlüsse geschaltet werden.
Beiläufig sei erwähnt, daß sich die Erfindung auch mit einem Speicher verwirklichen läßt, in dem die Speicher- und die Auswahltransistoren als P-Kanal-Transistoren ausgebildet sind, wenn der Transfertransistor dann als N-Kanal-Transistor ausgeführt wird. Eine solche Anordnung ist jedoch eher ungebräuchlich, kann jedoch Vorteile mit sich bringen, wenn eine sogenannte "Lochleitung" zur Übermittlung von Ladungsträgern erwünscht ist.

In Weiterbildung der Erfindung weist die Ansteuerschaltung einen N-Kanal-Entladetransistor auf, der einen Entlade-Gateanschluß sowie einen ersten und einen zweiten Entlade-Kanalanschluß aufweist, wobei der erste Entlade-Kanalanschluß mit dem Speicher-Gateanschluß in Verbindung steht, wobei der zweite Entlade-Kanalanschluß mit Masse verbunden ist und wobei der Entlade-Gateanschluß mit derjenigen Kontrolleitung in Verbindung steht, über die der Transfertransistor angesteuert wird.

Ein solcher Entladetransistor stellt während der Programmierung der Speicherzelle sicher, daß sich der Speicher-Gateanschluß bei einem Programmiervorgang auf einem definierten Potential, insbesondere auf Masse-Potential befindet. Gerade bei gesperrtem Transfertransistor ist dadurch gewährleistet, daß sich der Speicher-Gateanschluß definiert auf einem Potential von 0V befindet.

Der erfindungsgemäße Halbleiterspeicher ist in Zeilen und Spalten organisiert, wobei innerhalb der Zeilen die Auswahl-Gateanschlüsse und die Speicher-Gateanschlüsse mehrerer Speicherzellen parallel geschaltet sind und wobei innerhalb der Spalten die ersten Speicher-Kanalanschlüsse bzw. die zweiten Auswahl-Kanalanschlüsse parallel geschaltet sind. Auf diese Weise läßt sich ein erfindungsgemäßer Speicher besonders einfach in Zeilen und Spalten anordnen.

Dabei ist wenigstens eine Spalte vorgesehen, deren Ansteuerschaltung den erfindungsgemäß verschalteten Transfertransistor aufweist. Die Ansteuerschaltung kann zusätzlich je einen P-Kanal-Blockauswahltransistor mit einem Blockauswahl-Gateanschluß sowie mit zwei Blockauswahl-Kanalanschlüssen aufweisen, wobei ein erster Blockauswahl-Kanalanschluß mit einer zu einer Speicherzelle führenden Zeilenleitung in Verbindung steht und wobei ein zweiter Blockauswahl-Kanalanschluß mit dem ersten Transfer-Kanalanschluß in Verbindung steht. Dadurch kann der Halbleiterspeicher für das Programmieren der Speicherzellen in einzelne Blöcke aufgeteilt werden, was besonders vorteilhaft ist, da es dadurch nicht mehr notwendig ist, bestimmte Zustände für eine ganze Zeile des Halbleiterspeichers zu programmieren, sondern nur noch für einen aus dieser Zeile ausgewählten Block. Dadurch ist es auch insbesondere möglich, einen einzelnen Block zu löschen. Hierzu ist eine Blockauswahl-Kontrolleitung vorgesehen, die derart mit den Blockauswahl-Gateanschlüssen in Verbindung steht, daß die Blockauswahltransistoren über die Blockauswahl-Kontrolleitung ansteuerbar sind.

Die Erfindung betrifft auch generell eine Ansteuerschaltung zur Ansteuerung wenigstens einer Speicherzelle mit einem wie vorstehend verschalteten Transfertransistor.

Die Erfindung ist in der Zeichnung anhand zweier Ausführungsbeispiele näher beschrieben.
- Figur 1: zeigt ein Schaltbild eines ersten erfindungsgemäßen Halbleiterspeichers und
- Figur 2: zeigt ein Schaltbild eines zweiten erfindungsgemäßen Halbleiterspeichers.

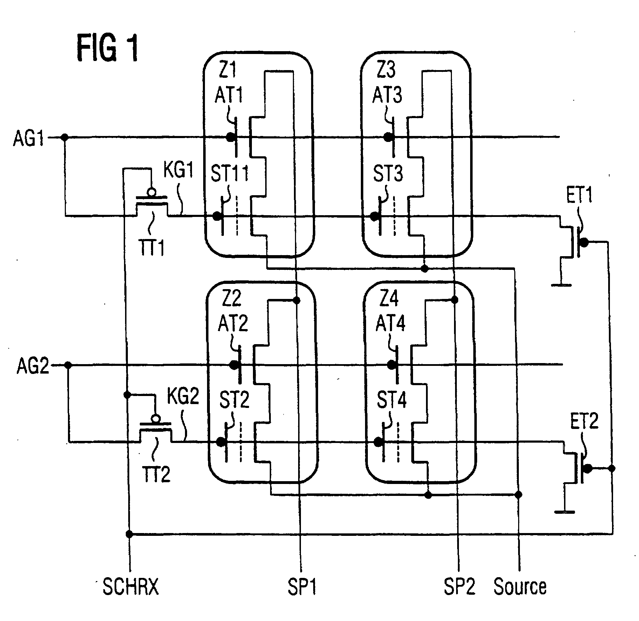

Figur 1 zeigt ein Schaltbild eines ersten erfindungsgemäßen Halbleiterspeichers, der auf einem Halbleitersubstrat ausgeführt ist. In Figur 1 ist nur ein Teilbereich des Halbleiterspeichers dargestellt, der vier Speicherzellen Z1, Z2, Z3 und Z4 aufweist. Die Speicherzellen Z1, Z2, Z3 und Z4 sind über zwei Zeilenleitungen AG1, AG2 und über zwei Spaltenleitungen SP1, SP2 ansteuerbar.

Zur Ansteuerung der Speicherzellen Z1, Z2, Z3 und Z4 dient eine Ansteuerschaltung, die einen Transfertransistor TT1, einen Entladetransistor ET1, einen Transfertransistor TT2 sowie einen Entladetransistor ET2 aufweist, die über eine Schreib-Signalleitung SCHRX angesteuert werden. Auf der Schreib-Signalleitung SCHRX liegt ein auf Hochspannung gewandeltes Signal an, das aus einem Logiksignal generiert ist, das den Schreibvorgang steuert.

Der Transfertransistor TT1 und der Transfertransistor TT2 sind als P-Kanal-Transistoren in FET-Technologie hergestellt, wohingegen der Entladetransistor ET1 und der Entladetransistor ET2 als N-Kanal-Transistoren in FET-Technologie ausgeführt sind.
Die Speicherzelle Z1 weist einen Auswahltransistor AT1 und einen Speichertransistor ST1 auf. Der Auswahltransistor AT1 ist als herkömmlicher N-Kanal-Transistor in FET-Technologie hergestellt, während der Speichertransistor ST1 als N-Kanal-Transistor mit einem sogenannten "Floating Gate" ausgeführt ist. Ein erster Auswahl-Kanalanschluß des Auswahltransistors AT1 steht mit der Spaltenleitung SP1 in Verbindung, während ein zweiter Auswahl-Kanalanschluß des Auswahltransistors AT1 mit einem ersten Speicher-Kanal-Anschluß des Speichertransistors ST1 verbunden ist. Ein zweiter Speicher-Kanalanschluß des Speichertransistors ST1 ist mit einer gemeinsamen Sourceleitung SOURCE verbunden.

Ein Auswahl-Gateanschluß des Auswahltransistors AT1 steht mit der Zeilenleitung AG1 in Verbindung. Ebenso ist ein zweiter Transfer-Kanalanschluß des Transfertransistors TT1 mit der Zeilenleitung AG1 verbunden. Ein erster Transfer-Kanalanschluß des Transfertransistors TT1 ist mit einem Speicher-Gateanschluß KG1 des Speichertransistors ST1 verbunden. Das zum Speicher-Gateanschluß KG1 gehörende Gate des Speichertransistors ST1 ist dabei als sogenanntes "Floating Gate" ausgeführt.

Ein Transfer-Gateanschluß des Transfertransistors TT1 ist mit der Schreib-Signalleitung SCHRX verbunden. Ein Entlade-Gateanschluß des Entladetransistors ET1 ist ebenso mit der Schreib-Signalleitung SCHRX verbunden. Ein erster Entlade-Kanalanschluß des Entladetransistors ET1 ist mit dem Speicher-Gateanschluß KG1 verbunden, während ein zweiter Entlade-Kanalanschluß des Entladetransistors ET1 direkt zu Masse geführt ist.

Die Speicherzelle Z3 ist bezüglich der Zeilenleitung AG1 zu der Speicherzelle Z1 parallel geschaltet. Die Speicherzelle Z3 weist hierzu einen Auswahltransistor AT3, der in herkömmlicher FET-Technologie als N-Kanal-Transistor ausgeführt ist, sowie einen Speichertransistor ST3 auf, der als N-Kanal-Transistor mit einem "Floating Gate" ausgebildet ist. Ein erster Auswahl-Kanalanschluß des Auswahltransistors AT3 steht mit der Spaltenleitung SP2 in Verbindung, während ein zweiter Auswahl-Kanalanschluß des Auswahltransistors AT3 mit einem ersten Speicher-Kanalanschluß des Speichertransistors ST3 in Verbindung steht. Ein zweiter Speicher-Kanalanschluß des Speichertransistors ST3 ist mit der gemeinsamen Sourceleitung SOURCE verbunden. Der Auswahl-Gateanschluß des Auswahltransistors AT3 ist parallel zum Auswahl-Gateanschluß des Auswahltransistors AT1 geschaltet und mit der Zeilenleitung AG1 verbunden.

Der Speicher-Gateanschluß des Speichertransistors ST3 ist parallel zu dem Speicher-Gateanschluß des Speichertransistors ST1 geschaltet und steht mit dem zweiten Transfer-Kanalanschluß des Transfertransistors TT1 in Verbindung. Demzufolge steht der Speicher-Gateanschluß des Speichertransistors ST3 auch mit dem ersten Entlade-Kanalanschluß des Entladetransistors ET1 in Verbindung.

Die Speicherzelle Z2 weist einen Auswahltransistor AT2 und einen Speichertransistor ST2 auf. Der Auswahltransistor AT2 ist als herkömmlicher N-Kanal-Transistor in FET-Technologie hergestellt, während der Speichertransistor ST2 als N-Kanal-Transistor mit einem sogenannten "Floating Gate" ausgeführt ist. Ein erster Auswahl-Kanalanschluß des Auswahltransistors AT2 steht mit der Spaltenleitung SP2 in Verbindung, während ein zweiter Auswahl-Kanalanschluß des Auswahltransistors AT2 mit einem ersten Speicher-Kanal-Anschluß des Speichertransistors ST2 verbunden ist. Ein zweiter Speicher-Kanalanschluß des Speichertransistors ST2 ist mit der gemeinsamen Sourceleitung SOURCE verbunden.

Ein Auswahl-Gateanschluß des Auswahltransistors AT2 steht mit der Zeilenleitung AG2 in Verbindung. Ebenso ist ein zweiter Transfer-Kanalanschluß des Transfertransistors TT2 mit der Zeilenleitung AG2 verbunden. Ein erster Transfer-Kanalanschluß des Transfertransistors TT2 ist mit einem Speicher-Gateanschluß KG2 des Speichertransistors ST2 verbunden. Das zum Speicher-Gateanschluß KG2 gehörende Gate des Speichertransistors ST2 ist dabei als sogenanntes "Floating Gate" ausgeführt.

Ein Transfer-Gateanschluß des Transfertransistors TT2 und ein in Entlade-Gateanschluß des Entladetransistors ET2 sind mit der Schreib-Signalleitung SCHRX verbunden. Ein erster Entlade-Kanalanschluß ist mit dem Speicher-Gateanschluß KG2 verbunden, während ein zweiter Entlade-Kanalanschluß direkt zu Masse geführt ist. Die Speicherzelle Z4 ist bezüglich der Zeilenleitung AG2 zu der Speicherzelle Z2 parallel geschaltet. Die Speicherzelle Z4 weist hierzu einen Auswahltransistor AT4, der in herkömmlicher FET-Technologie als N-Kanal-Transistor ausgeführt ist, sowie einen Speichertransistor ST4 auf, der als N-Kanal-Transistor mit einem "Floating Gate" ausgebildet ist. Ein erster Auswahl-Kanalanschluß des Auswahltransistors AT4 steht mit der Spaltenleitung SP2 in Verbindung, während ein zweiter Auswahl-Kanalanschluß des Auswahltransistors AT4 mit einem ersten Speicher-Kanalanschluß des Speichertransistors ST4 in Verbindung steht. Ein zweiter Speicher-Kanalanschluß des Speichertransistors ST4 ist mit der gemeinsamen Sourceleitung SOURCE verbunden. Der Auswahl-Gateanschluß des Auswahltransistors AT4 ist parallel zum Auswahl-Gateanschluß des Auswahltransistors AT2 geschaltet und mit der Zeilenleitung AG2 verbunden. Der Speicher-Gateanschluß des Speichertransistors ST4 ist parallel zu dem Speicher-Gateanschluß des Speichertransistors ST2 geschaltet und steht mit dem zweiten Transfer-Kanalanschluß des Transfertransistors TT2 in Verbindung. Demzufolge steht der Speicher-Gateanschluß des Speichertransistors ST4 auch mit dem ersten Entlade-Kanalanschluß des Entladetransistors ET2 in Verbindung.

Bezüglich der Spaltenleitung SP1 sind die Speicherzellen Z1, Z2 parallel geschaltet, während die die Speicherzellen Z3, Z4 bezüglich der Spaltenleitung SP2 parallel geschaltet sind.

Nachfolgend werden die drei Zustände "Löschen", "Schreiben" und "Lesen" für die Speicherzelle Z1 erklärt. Dabei wird im Zustand "Löschen" an die Spaltenleitung SP1 kein Signal angelegt, da dies hierfür nicht notwendig ist. Lediglich beim Schreiben und beim Auslesen des Inhalts der Speicherzelle Z1 wird die Spaltenleitung SP1 mit einem Signal beaufschlagt. Dies ist hier jedoch nicht näher dargestellt, da dies für das Wesen der Erfindung von nachgeordneter Bedeutung ist.

In der nachfolgenden Tabelle sind die Zustände der Zeilenleitungen AG1, AG2, der Speicher-Gateanschlüsse KG1, KG2 und der Schreib-Signalleitung SCHRX für die einzelnen Betriebszustände dargestellt:

| | AG1 | KG1 | AG2 | KG2 | SCHRX |
|---|---|---|---|---|---|
| Löschen | Up | Up | 0 | 0+Utp | 0 |
| Schreiben | Up | 0 | 0 | 0 | Up |
| Lesen | U1 | U1 | 0 | 0+Utp | 0 |

Dabei bezeichnet die Spannung "Up" die Programmierungsspannung (z.B. 18 V), die Spannung "U1" eine Auslesespannung und die Spannung "Utp" der positive Absolutbetrag der Schwellenspannung eines p-Kanal-Transistors (ca. 1 V).

Wie man aus der Tabelle deutlich sieht, wird beim Löschen der Zeile des Speichers, in der sich die Speicherzelle Z1 befindet, an die Zeilenleitung AG1 eine Programmierspannung Up angelegt. Dadurch liegt der erste Transfer-Kanalanschluß des Transfertransistors TT1 ebenfalls auf dem Niveau der Programmierspannung Up. Auf der Schreib-Signalleitung SCHRX liegt die Spannung 0V an, so daß sich der Transfertransistor TT1 in durchgeschaltetem Zustand befindet, da er als P-Kanal-Transistor ausgeführt. Demgegenüber ist der Entladetransistor ET1 als N-Kanal-Transistor ausgeführt, so daß das an dem Entlade-Gateanschluß des Entladetransistors ET1 anliegende Signal OV der Schreib-Signalleitung SCHRX diesen in einen gesperrten Zustand bewegt. Infolgedessen liegt an dem Speicher-Gateanschluß KG1 die Programmierspannung Up an, was das "Floating Gate" des Speichertransistors ST1 in den "gelöschten" Zustand zwingt.

Die Speicherzelle Z2 bleibt von den Vorgängen auf der Zeilenleitung AG1 sowie auf der Schreib-Signalleitung SCHRX insofern unberührt, als sich der Speicher-Gateanschluß KG2 stets entsprechend dem Potential der Zeilenleitung AG2 in einem definierten Zustand auf 0V + Utp befindet.

Da die Speicherzellen Z3 und Z4 bezüglich der Zeilenleitungen AG1, AG2 parallel zu den Speicherzellen Z1 und Z2 geschaltet sind, verhalten sich diese entsprechend zu diesen Speicherzellen Z1 und Z2. Daher werden beim Zustand "Löschen" alle diejenigen Speicherzellen gelöscht, die mit der Zeilenleitung AG1 angesprochen werden.

Das Löschen der Speicherzelle Z2 und der Speicherzelle Z4 erfolgt entsprechend zum Löschen der Speicherzellen Z1 und Z3.

Beim Schreiben eines Werts in die Speicherzelle Z1 werden die Zeilenleitung AG1 und die Schreib-Signalleitung SCHRX mit dem Wert Up beaufschlagt. Aufgrund des Zustands der Schreib-Signalleitung SCHRX schaltet der N-Kanal-Entladetransistor ET1 durch, während der P-Kanal-Transfertransistor TT1 sperrt. Dadurch liegt auf dem Speicher-Gateanschluß KG1 das Potential von Masse an, nämlich 0V. Durch Anlegen eines geeigneten Signals an die Spaltenleitung SP1 wird der Speichertransistor ST1 beschrieben, da der Auswahltransistor AT1 aufgrund des am Auswahl-Gateanschluß anliegenden Signals Up durchgeschaltet ist.

Dabei ist zu bemerken, daß die Speicherzelle Z2 von den Vorgängen in der Speicherzelle Z1 insofern unberührt bleibt, da der Speicher-Gateanschluß KG2 stets entsprechend dem Potential der durch den Entladetransistor ET2 geschalteten Masse den definierten Wert 0V beibehält.

Beim Auslesen eines Wertes aus der Speicherzelle Z1 wird auf der Zeilenleitung AG1 der Wert U1 angelegt, während die Schreib-Signalleitung SCHRX mit dem Signal 0 beaufschlagt wird. Dadurch befindet sich der Speicher-Gateanschluß KG1 definiert auf dem Potential U1, während sich der Auswahltransistor AT1 in durchgeschaltetem Zustand befindet. Durch Anlegen einer geeigneten Spannung an die Spaltenleitung SP1 kann dann der Zustand des Speichertransistors ST1 ausgelesen werden.

Durch Anlegen einer geeigneten Spannung an die Spaltenleitung SP2 kann in diesem Betriebsmodus der Speicherzustand des Speichertransistors ST3 der Speicherzelle Z3 ausgelesen werden, da sich der Auswahltransistor AT3 ebenfalls in durchgeschaltetem Zustand befindet. Die Speicherzellen Z2 und Z4 bleiben von dem Zustand der Speicherzellen Z1 und Z3 insofern unberührt, als sich der Speicher-Gateanschluß KG2 stets in einem definierten Zustand auf 0V + Utp befindet, da der Speicher-Gateanschluß KG2 stets entsprechend dem Potential der durch den Entladetransistor ET2 geschalteten Masse den definierten Wert 0V + Utp beibehält.

Die Spaltenleitungen SP1 und SP2 werden sowohl beim Schreiben als auch beim Lesen mit entsprechenden Standardwerten beschaltet.

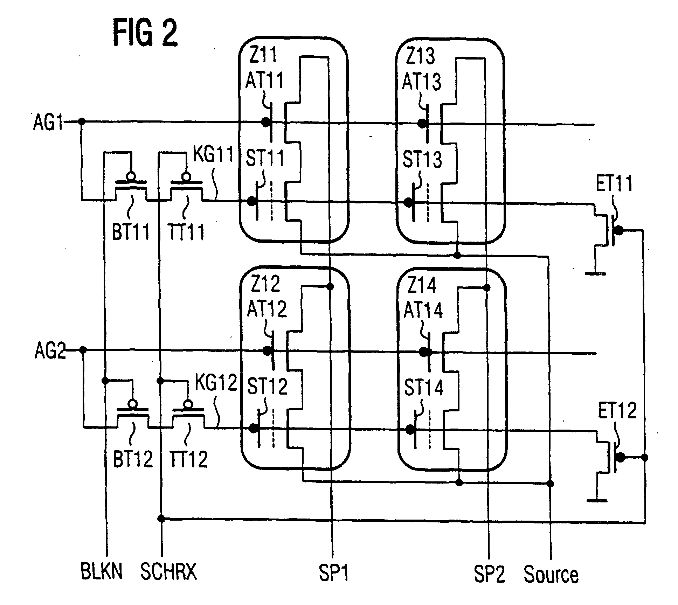

Figur 2 zeigt ein Schaltbild eines weiteren erfindungsgemäßen Halbleiterspeichers, der auf einem Halbleitersubstrat ausgeführt ist. In Figur 2 ist nur ein Teilbereich des Halbleiterspeichers dargestellt, der vier Speicherzellen Z11, Z12, Z13 und Z14 aufweist. Die Speicherzellen Z11, Z12, Z13 und Z14 sind über zwei Zeilenleitungen AG1, AG2 und über zwei Spaltenleitungen SP1, SP2 ansteuerbar.

Zur Ansteuerung der Speicherzellen Z11, Z12, Z13 und Z14 dient eine Ansteuerschaltung, die einen Transfertransistor TT11, einen Entladetransistor ET11, einen Transfertransistor TT12 sowie einen Entladetransistor ET12 aufweist, die über eine Schreib-Signalleitung SCHRX angesteuert werden. Auf der Schreib-Signalleitung SCHRX liegt ein auf Hochspannung gewandeltes Signal an, das aus einem Logiksignal generiert ist, das den Schreibvorgang steuert. Die Ansteuerschaltung umfaßt weiterhin einen Blockauswahltransistor BT11 sowie einen Blockauswahltransistor BT12. Ein Blockauswahl-Gateanschluß des Blockauswahltransistors BT11 sowie ein Blockauswahl-Gateanschluß des Blockauswahltransistors BT12 sind mit einer Blockauswahl-Signalleitung BLKN verbunden. Auf der Blockauswahl-Signalleitung BLKN liegt ein auf Hochspannung gewandeltes Signal an, das aus einem weiteren Logiksignal generiert ist, das den blockweisen Programmiervorgang steuert.

### Einfügung

Die Transfertransistoren TT11 und TT2 und die Blockauswahltransistoren BT11 und BT12 sind als herkömmliche P-Kanal-Transistoren in FET-Technologie hergestellt.

Die Speicherzelle Z11 weist einen Auswahltransistor AT11 und einen Speichertransistor ST11 auf. Der Auswahltransistor AT11 ist als herkömmlicher N-Kanal-Transistor in FET-Technologie hergestellt, während der Speichertransistor ST11 als N-Kanal-Transistor mit einem sogenannten "Floating Gate" ausgeführt ist. Ein erster Auswahl-Kanalanschluß des Auswahltransistors AT11 steht mit der Spaltenleitung SP1 in Verbindung, während ein zweiter Auswahl-Kanalanschluß des Auswahltransistors AT11 mit einem ersten Speicher-Kanal-Anschluß des Speichertransistors ST11 verbunden ist. Ein zweiter Speicher-Kanalanschluß des Speichertransistors ST11 ist mit einer gemeinsamen Sourceleitung SOURCE verbunden.

Ein Auswahl-Gateanschluß des Auswahltransistors AT11 steht mit der Zeilenleitung AG1 in Verbindung. Ebenso ist ein zweiter Blockauswahl-Kanalanschluß des Blockauswahltransistors BT11 mit der Zeilenleitung AG1 verbunden. Ein zweiter Transfer-Kanalanschluß des Transfertransistors TT11 ist mit einem ersten Blockauswahl-Kanalanschluß der Blockauswahltransistors BT11 verbunden und ein erster Transfer-Kanalanschluß des Transfertransistors TT11 ist mit einem Speicher-Gateanschluß KG11 des Speichertransistors ST11 verbunden. Das zum Speicher-Gateanschluß KG11 gehörende Gate des Speichertransistors ST11 ist dabei als sogenanntes "Floating Gate" ausgeführt. Ein Transfer-Gateanschluß des Transfertransistors TT11 ist mit der Schreib-Signalleitung SCHRX verbunden.

Ein Entlade-Gateanschluß des Entladetransistors ET11 mit der Schreib-Signalleitung SCHRX verbunden. Ein erster Entlade-Kanalanschluß ist mit dem Speicher-Gateanschluß KG11 verbunden, während ein zweiter Entlade-Kanalanschluß direkt zu Masse geführt ist.

Die Speicherzelle Z13 ist bezüglich der Zeilenleitung AG1 zu der Speicherzelle Z11 parallel geschaltet. Die Speicherzelle Z13 weist hierzu einen Auswahltransistor AT13, der in herkömmlicher FET-Technologie als N-Kanal-Transistor ausgeführt ist, sowie einen Speichertransistor ST13 auf, der als N-Kanal-Transistor mit einem "Floating Gate" ausgebildet ist. Ein erster Auswahl-Kanalanschluß des Auswahltransistors AT13 steht mit der Spaltenleitung SP2 in Verbindung, während ein zweiter Auswahl-Kanalanschluß des Auswahltransistors AT13 mit einem ersten Speicher-Kanalanschluß des Speichertransistors ST13 in Verbindung steht. Ein zweiter Speicher-Kanalanschluß des Speichertransistors ST13 ist mit der gemeinsamen Sourceleitung SOURCE verbunden. Der Auswahl-Gateanschluß des Auswahltransistors AT13 ist parallel zum Auswahl-Gateanschluß des Auswahltransistors AT11 geschaltet und mit der Zeilenleitung AG1 verbunden. Der Speicher-Gateanschluß des Speichertransistors ST13 ist parallel zu dem Speicher-Gateanschluß des Speichertransistors ST11 geschaltet und steht mit dem zweiten Transfer-Kanalanschluß des Transfertransistors TT11 in Verbindung. Demzufolge steht der Speicher-Gateanschluß des Speichertransistors ST13 auch mit dem ersten Entlade-Kanalanschluß des Entladetransistors ET11 in Verbindung.

Die Speicherzelle Z12 weist einen Auswahltransistor AT12 und einen Speichertransistor ST12 auf. Der Auswahltransistor AT12 ist als herkömmlicher N-Kanal-Transistor in FET-Technologie hergestellt, während der Speichertransistor ST12 als N-Kanal-Transistor mit einem sogenannten "Floating Gate" ausgeführt ist. Ein erster Auswahl-Kanalanschluß des Auswahltransistors AT12 steht mit der Spaltenleitung SP2 in Verbindung, während ein zweiter Auswahl-Kanalanschluß des Auswahltransistors AT12 mit einem ersten Speicher-Kanal-Anschluß des Speichertransistors ST12 verbunden ist. Ein zweiter Speicher-Kanalanschluß des Speichertransistors ST12 ist mit der gemeinsamen Sourceleitung SOURCE verbunden.

Ein Auswahl-Gateanschluß des Auswahltransistors AT12 steht mit der Zeilenleitung AG2 in Verbindung. Ebenso ist ein zweiter Blockauswahl-Kanalanschluß des Blockauswahltransistors BT12 mit der Zeilenleitung AG2 verbunden. Ein zweiter Transfer-Kanalanschluß des Transfertransistors TT12 ist mit einem ersten Blockauswahl-Kanalanschluß der Blockauswahltransistors BT12 verbunden und ein erster Transfer-Kanalanschluß des Transfertransistors TT12 ist mit einem Speicher-Gateanschluß KG12 des Speichertransistors ST12 verbunden. Das zum Speicher-Gateanschluß KG12 gehörende Gate des Speichertransistors ST12 ist dabei als sogenanntes "Floating Gate" ausgeführt.

Ein Transfer-Gateanschluß des Transfertransistors TT12 ist mit der Schreib-Signalleitung SCHRX verbunden. Ein Blockauswahl-Gateanschluß des Blockauswahltransistors BT12 ist mit der Blockauswahl-Signalleitung BLKN verbunden.

Ein Entlade-Gateanschluß des Entladetransistors ET12 mit der Schreib-Signalleitung SCHRX verbunden. Ein erster Entlade-Kanalanschluß ist mit dem Speicher-Gateanschluß KG12 verbunden, während ein zweiter Entlade-Kanalanschluß direkt zu Masse geführt ist.

Die Speicherzelle Z14 ist bezüglich der Zeilenleitung AG2 zu der Speicherzelle Z12 parallel geschaltet. Die Speicherzelle Z14 weist hierzu einen Auswahltransistor AT14, der in herkömmlicher FET-Technologie als N-Kanal-Transistor ausgeführt ist, sowie einen Speichertransistor ST14 auf, der als N-Kanal-Transistor mit einem "Floating Gate" ausgebildet ist. Ein erster Auswahl-Kanalanschluß des Auswahltransistors AT14 steht mit der Spaltenleitung SP2 in Verbindung, während ein zweiter Auswahl-Kanalanschluß des Auswahltransistors AT14 mit einem ersten Speicher-Kanalanschluß des Speichertransistors ST14 in Verbindung steht. Ein zweiter Speicher-Kanalanschluß des Speichertransistors ST14 ist mit der gemeinsamen Sourceleitung SOURCE verbunden. Der Auswahl-Gateanschluß des Auswahltransistors AT14 ist parallel zum Auswahl-Gateanschluß des Auswahltransistors AT12 geschaltet und mit der Zeilenleitung AG2 verbunden. Der Speicher-Gateanschluß des Speichertransistors ST14 ist parallel zu dem Speicher-Gateanschluß des Speichertransistors ST12 geschaltet und steht mit dem zweiten Transfer-Kanalanschluß des Transfertransistors TT12 in Verbindung. Demzufolge steht der Speicher-Gateanschluß des Speichertransistors ST14 auch mit dem ersten Entlade-Kanalanschluß des Entladetransistors ET12 in Verbindung.

Bezüglich der Spaltenleitung SP1 sind die Speicherzellen Z11, Z12 parallel geschaltet, während die die Speicherzellen Z13, Z14 bezüglich der Spaltenleitung SP2 parallel geschaltet sind.

Nachfolgend werden die drei Zustände "Löschen", "Schreiben" und "Lesen" für die Speicherzelle Z11 erklärt. Dabei wird im Zustand "Löschen" an die Spaltenleitung SP1 kein Signal angelegt, da dies hierfür nicht notwendig ist. Lediglich beim Schreiben und beim Auslesen des Inhalts der Speicherzelle Z11 wird die Spaltenleitung SP1 mit einem Signal beaufschlagt. Dies ist hier jedoch nicht näher dargestellt, da dies für das Wesen der Erfindung von nachgeordneter Bedeutung ist.

In der nachfolgenden Tabelle sind die Zustände der Zeilenleitungen AG1, AG2, der Speicher-Gateanschlüsse KG11, KG12 und der Schreib-Signalleitung SCHRX für die einzelnen Betriebszustände dargestellt:

| | AG1 | KG11 | AG2 | KG12 | SCHRX |
|---|---|---|---|---|---|
| Löschen | Up | Up | 0 | 0+Utp | 0 |
| Schreiben | Up | 0 | 0 | 0 | Up |
| Lesen | U1 | U1 | 0 | 0+Utp | 0 |

Das Blockauswahlsignal BLKN nimmt je nachdem, ob der Block des Halbleiterspeichers, in dem sich die Speicherzellen Z1 bis Z4 befinden, ausgewählt ist oder nicht, die Spannungen OV ("ausgewählt") bzw. Up ("nicht ausgewählt") an.

Dabei bezeichnet die Spannung "Up" die Programmierungsspannung (z.B. 18 V), die Spannung "U1" eine Auslesespannung und die Spannung "Utp" der positive Absolutbetrag der Schwellenspannung eines p-Kanal-Transistors (ca. 1 V).

Für die nachfolgende Beschreibung der Arbeitsweise des Halbleiterspeichers wird angenommen, daß sich das Signal BLKN stets auf 0V befindet, so daß sich die Kanäle der Blockauswahltransistoren in durchgeschaltetem Zustand befinden und die Signale auf den Zeilenleitungen an die Kanäle der Transfertransistoren TT11 und TT12 weiterleiten.

Wie man aus der Tabelle deutlich sieht, wird beim Löschen der Zeile des Speichers, in der sich die Speicherzelle Z11 befindet, an die Zeilenleitung AG1 eine Programmierspannung Up angelegt. Dadurch liegt der erste Transfer-Kanalanschluß des Transfertransistors TT11 ebenfalls auf dem Niveau der Programmierspannung Up. Auf der Schreib-Signalleitung SCHRX liegt die Spannung 0V an, so daß sich der Transfertransistor TT11 in durchgeschaltetem Zustand befindet, da er als P-Kanal-Transistor ausgeführt. Demgegenüber ist der Entladetransistor ET11 als N-Kanal-Transistor ausgeführt, so daß das an dem Entlade-Gateanschluß des Entladetransistors ET11 anliegende Signal 0V der Schreib-Signalleitung SCHRX diesen in einen gesperrten Zustand bewegt. Infolgedessen liegt an dem Speicher-Gateanschluß KG11 die Programmierspannung Up an, was das "Floating Gate" des Speichertransistors ST11 in den "gelöschten" Zustand zwingt.

Die Speicherzelle Z12 bleibt von den Vorgängen auf der Zeilenleitung AG1 sowie auf der Schreib-Signalleitung SCHRX insofern unberührt, als sich der Speicher-Gateanschluß KG12 stets entsprechend dem Potential der Zeilenleitung AG2 in einem definierten Zustand auf 0V + Utp befindet.

Da die Speicherzellen Z13 und Z14 bezüglich der Zeilenleitungen AG1, AG2 parallel zu den Speicherzellen Z11 und Z12 geschaltet sind, verhalten sich diese entsprechend zu diesen Speicherzellen Z11 und Z12. Daher werden beim Zustand "Löschen" alle diejenigen Speicherzellen gelöscht, die mit der Zeilenleitung AG1 angesprochen werden.

Das Löschen der Speicherzelle Z12 und der Speicherzelle Z14 erfolgt entsprechend zum Löschen der Speicherzellen Z11 und Z13. Beim Schreiben eines Werts in die Speicherzelle Z11 werden die Zeilenleitung AG1 und die Schreib-Signalleitung SCHRX mit dem Wert Up beaufschlagt. Aufgrund des Zustands der Schreib-Signalleitung SCHRX schaltet der N-Kanal-Entladetransistor ET11 durch, während der P-Kanal-Transfertransistor TT11 sperrt. Dadurch liegt auf dem Speicher-Gateanschluß KG11 das Potential von Masse an, nämlich 0V. Durch Anlegen eines geeigneten Signals an die Spaltenleitung SP1 wird der Speichertransistor ST11 beschrieben, da der Auswahltransistor AT11 aufgrund des am Auswahl-Gateanschluß anliegenden Signals Up durchgeschaltet ist. Dabei ist zu bemerken, daß die Speicherzelle Z12 von den Vorgängen in der Speicherzelle Z11 insofern unberührt bleibt, da der Speicher-Gateanschluß KG12 stets entsprechend dem Potential der durch den Entladetransistor geschalteten Masse den definierten Wert 0V beibehält. Beim Auslesen eines Wertes aus der Speicherzelle Z11 wird auf der Zeilenleitung AG1 der Wert U1 angelegt, während die Schreib-Signalleitung SCHRX mit dem Signal 0 beaufschlagt wird. Dadurch befindet sich der Speicher-Gateanschluß KG11 definiert auf dem Potential U1, während sich der Auswahltransistor AT11 in durchgeschaltetem Zustand befindet. Durch Anlegen einer geeigneten Spannung an die Spaltenleitung SP1 kann dann der Zustand des Speichertransistors ST11 ausgelesen werden. Durch Anlegen einer geeigneten Spannung an die Spaltenleitung SP2 kann in diesem Betriebsmodus der Speicherzustand des Speichertransistors ST13 der Speicherzelle Z13 ausgelesen werden, da sich der Auswahltransistor AT13 ebenfalls in durchgeschaltetem Zustand befindet. Die Speicherzellen Z12 und Z14 bleiben von dem Zustand der Speicherzellen Z11 und Z13 insofern unberührt, als sich der Speicher-Gateanschluß KG12 stets in einem definierten Zustand auf 0V + Utp befindet, und zwar aufgrund der durch den Entladetransistor geschalteten Masse. Die Spaltenleitungen SP1 und SP2 werden sowohl beim Schreiben als auch beim Lesen mit den entsprechenden Standardwerten beschaltet.

## Patentansprüche

1. Halbleiterspeicher mit wenigstens einer Speicherzelle, die die folgenden Merkmale aufweist:
- es ist ein N-Kanal-Auswahltransistor (AT1, AT2; AT11, AT12) sowie ein N-Kanal-Speichertransistor (ST1, ST2; ST11, ST12) vorgesehen,
- der N-Kanal-Auswahltransistor (AT1, AT2; AT11, AT12) weist einen Auswahl-Gateanschluß sowie zwei AuswahlKanalanschlüsse auf, wobei der Auswahl-Gateanschluß mit einer zu der Speicherzelle (Z1, Z2: Z11, Z12) führenden Zeilenleitung (AG1) in Verbindung steht,
- der N-Kanal-Speichertransistor (ST1, ST2; ST11, ST12) weist einen Speicher-Gateanschluß (KG1, KG2; KG11, KG12) sowie zwei Speicher-Kanalanschlüsse auf,
- ein zweiter Speicher-Kanalanschluß und ein erster Auswahl-Kanalanschluß stehen miteinander in Verbindung, wobei ein erster Speicher-Kanalanschluß bzw. ein zweiter Auswahl-Kanalanschluß mit einer zu der Speicherzelle (Z1, Z2; Z11, Z12) führenden Spaltenleitung (SPD verbunden ist, wobei der Halbleiterspeicher wenigstens einen Transfertransistor (TT1, TT2; TT11, TT12) mit einem ersten und einem zweiten Transfer-Kanalanschluß aufweist, wobei der erste Transfer-Kanalanschluß mit dem Speicher-Gateanschluß (KG1, KG2; KG11, KG12) in Verbindung steht,
**gekennzeichnet durch** die folgenden Merkmale:
- der Transfertransistor ist als P-Kanal-Transfertransistor (TT1, TT2; TT11, TT12) ausgeführt,
- der zweite Transfer-Kanalanschluß steht mit der zu der Speicherzelle (Z1, Z2; Z11, Z12) führenden Zeilenleitung (AG1, AG2; AG11, AG12) in Verbindung.

2. Halbleiterspeicher nach Anspruch 1,
**dadurch gekennzeichnet, daß** eine Kontrolleitung (SCHRX) vorgesehen ist, die derart mit dem Tranfer-Gateanschluß verbunden ist, daß der Transfertransistor (TT1, TT2; TT11, TT12) über die Kontrolleitung (SCHRX) ansteuerbar ist.

3. Halbleiterspeicher nach Anspruch 2,
**dadurch gekennzeichnet, daß** ein N-Kanal-Entladetransistor (ET1, ET2; ET11, ET12) vorgesehen ist, der einen Entlade-Gateanschluß sowie einen ersten und einen zweiten Entlade-Kanalanschlüsse aufweist, wobei der erste Entlade-Kanalanschluß mit dem Speicher-Gateanschluß (KG1, KG2; KG11, KG12) verbunden ist, wobei der zweite Entlade-Kanalanschluß insbesondere mit Masse verbunden ist und wobei der Entlade-Gateanschluß mit der Kontrolleitung (SCHRX) verbunden ist.

4. Halbleiterspeicher nach einem der vorhergehenden Ansprüche, **dadurch gekennzeichnet, daß** er in Zeilen und Spalten orientiert ist, wobei innerhalb der Zeilen:
- die Auswahl-Gateanschlüsse mehrerer Speicherzellen (Z1, Z3; Z2, Z4; Z11, Z13; Z12, Z14) parallel geschaltet sind,
- die Speicher-Gateanschlüsse mehrerer Speicherzellen (Z1, Z3; Z2, Z4; Z11, Z13; Z12, Z14) parallel geschaltet sind, und wobei innerhalb der Spalten die ersten Speicher-Kanalanschlüsse bzw. die zweiten Auswahl-Kanalanschlüsse parallel geschaltet sind.

5. Halbleiterspeicher nach Anspruch 4,
**dadurch gekennzeichnet, daß** die Ansteuerschaltung wenigstens einer Spalte je einen P-Kanal Blockauswahltransistor (BT11, BT12) mit einem Blockauswahl-Gateanschluß sowie mit zwei Blockauswahl-Kanalanschlüssen aufweisen, wobei ein erster Blockauswahl-Kanalanschluß mit einer zu der Speicherzelle führenden Zeilenleitung (AG1, AG2) verbunden ist, und wobei ein zweiter Blockauswahl-Kanalanschluß mit dem ersten Transfer-Kanalanschluß verbunden ist.

6. Halbleiterspeicher nach Anspruch 5,
**dadurch gekennzeichnet, daß** eine Blockauswahl-Kontrolleitung (BLKN) vorgesehen ist, die derart mit den Blockauswahl-Gateallschlüssen verbunden ist, daß die Blockauswahltransistoren (BT11, BT12) über die Blockauswahl-Kontrolleitung (BLKN) ansteuerbar sind.

## Claims

1. Semiconductor memory having at least one memory cell which has the following features:
- an N-channel selection transistor (AT1, AT2; AT11, AT12) and an N-channel memory transistor (ST1, ST2; ST11, ST12) are provided,
- the N-channel selection transistor (AT1, AT2; AT11, AT12) has a selection gate terminal and two selection channel terminals, the selection gate terminal being connected to a row line (AG1) leading to the memory cell (Z1, Z2; Z11, Z12),
- the N-channel memory transistor (ST1, ST2; ST11, ST12) has a memory gate terminal (KG1, KG2; KG11, KG12) and two memory channel terminals,
- a second memory channel terminal and a first selection channel terminal are connected to one another, a first memory channel terminal or respectively a second selection channel terminal being connected to a column line (SP1) leading to the memory cell (Z1, Z2; Z11, Z12), the semiconductor memory having at least one transfer transistor (TT1, TT2; TT11, TT12) having a first and a second transfer channel terminal, the first transfer channel terminal being connected to the memory gate terminal (KG1, KG2; KG11, KG12),
**characterized by** the following features:
- the transfer transistor is designed as a P-channel transfer transistor (TT1, TT2; TT11, TT12),
- the second transfer channel terminal is connected to the row line (AG1, AG2; AG11, AG12) leading to the memory cell (Z1, Z2; Z11, Z12).

2. Semiconductor memory according to Claim 1,
**characterized in that** a control line (SCHRX) is provided, which is connected to the transfer gate terminal in such a way that the transfer transistor (TT1, TT2; TT11, TT12) can be driven via the control line (SCHRX).

3. Semiconductor memory according to Claim 2,
**characterized in that** an N-channel discharge transistor (ET1, ET2; ET11, ET12) is provided, which has a discharge gate terminal and a first and a second discharge channel terminals, the first discharge channel terminal being connected to the memory gate terminal (KG1, KG2; KG11, KG12), the second discharge channel terminal being connected, in particular, to earth, and the discharge gate terminal being connected to the control line (SCHRX).

4. Semiconductor memory according to one of the preceding claims, **characterized in that** it is oriented in rows and columns, where, within the rows:
- the selection gate terminals of a plurality of memory cells (Z1, Z3; Z2, Z4; Z11, Z13; Z12, Z14) are connected in parallel,
- the memory gate terminals of a plurality of memory cells (Z1, Z3; Z2, Z4; Z11, Z13; Z12, Z14) are connected in parallel,
and where, within the columns, the first memory channel terminals and respectively the second selection channel terminals are connected in parallel.

5. Semiconductor memory according to Claim 4,
**characterized in that** the drive circuit of at least one column respectively has a P-channel block selection transistor (BT11, BT12) having a block selection gate terminal and having two block selection channel terminals, a first block selection channel terminal being connected to a row line (AG1, AG2) leading to the memory cell, and a second block selection channel terminal being connected to the first transfer channel terminal.

6. Semiconductor memory according to Claim 5,
**characterized in that** a block selection control line (BLKN) is provided, which is connected to the block selection gate terminals in such a way that the block selection transistors (BT11, BT12) can be driven via the block selection control line (BLKN).

## Revendications

1. Mémoire à semi-conducteur comprenant au moins une cellule de mémoire qui a les caractéristiques suivantes :
- il est prévu un transistor (AT1, AT2 ; AT11, AT12) de sélection à canal N ainsi qu'un transistor (ST1, ST2 ; ST11, ST12) de mémoire à canal N,
- le transistor (AT1, AT2 ; AT11, AT12) de sélection à canal N comporte une borne de grille de sélection ainsi que deux bornes de canal de sélection, la borne de grille de sélection étant reliée à l'un des conducteurs (AG1) de ligne menant à la cellule (Z1, Z2 ; Z11, Z12) de mémoire,
- le transistor (ST1, ST2 ; ST11, ST12) de mémoire à canal N comporte une borne (KG1, KG2 ; KG11, KG12) de grille de mémoire ainsi que deux bornes de canal de mémoire,
- une deuxième borne de canal de mémoire et une première borne de canal de sélection sont reliées entre elles, une première borne de canal de mémoire ou une deuxième borne de canal de sélection étant reliées à l'un des conducteurs (SP1) de colonne menant à la cellule (Z1, Z2 ; Z11, Z12) de mémoire, la mémoire à semi-conducteur comprenant au moins un transistor (TT1, TT2 ; TT11, TT12) de transfert ayant une première et une deuxième bornes de canal de transfert, la première borne de canal de transfert étant reliée à la borne (KG1, KG2 ; KG11, KG12) de grille de mémoire,
**caractérisée par** les caractéristiques suivantes :
- le transistor de transfert est réalisé en transistor (TT1, TT2 ; TT11, TT12) de transfert à canal P,
la deuxième borne de canal de transfert est reliée au conducteur (AG1, AG2 ; AG11, AG12) de ligne menant à la cellule (Z1, Z2 ; Z11, Z12) de mémoire.

2. Mémoire à semi-conducteur suivant la revendication 1, **caractérisée en ce qu'**il est prévu un conducteur (SCHRX) de contrôle qui est relié à la borne de grille de transfert de manière que le transistor (TT1, TT2 ; TT11, TT12) de transfert puisse être commandé par le conducteur (SCHRX) de contrôle.

3. Mémoire à semi-conducteur suivant la revendication 2, **caractérisée en ce qu'**il est prévu un transistor (ET1, ET2 ; ET11, ET12) de décharge à canal N, qui comporte une borne de grille de décharge ainsi qu'une première et une deuxième bornes de canal de décharge, la première borne de canal de décharge étant reliée à la borne (KG1, KG2 ; KG11, KG12) de grille de mémoire, la deuxième borne de canal de décharge étant reliée notamment à la masse et la borne de grille de décharge étant reliée au conducteur (SCHRX) de contrôle.

4. Mémoire à semi-conducteur suivant l'une des revendications précédentes, **caractérisée en ce qu'**il est orienté en lignes et en colonnes, et dans les lignes :
- les bornes de grille de sélection de plusieurs cellules (Z1, Z3 ; Z2, Z4 ; Z11, Z13 ; Z12, Z14) de mémoire sont montées en parallèle,
- les bornes de grille de mémoire de plusieurs cellules (Z1, Z3 ; Z2, Z4 ; Z11, Z13 ; Z12, Z14) de mémoire sont montées en parallèle, et dans les colonnes les premières bornes de canal de mémoire et respectivement les deuxièmes bornes de canal de sélection sont montées en parallèle.

5. Mémoire à semi-conducteur suivant la revendication 4, **caractérisée en ce que** le circuit de commande comprend au moins une colonne pour chaque transistor (BT11, BT12) de sélection de bloc à canal P ayant une borne de grille de sélection de bloc ainsi que des bornes de canal de sélection de bloc, une première borne de canal de sélection de bloc étant reliée à l'un des conducteurs (AG1, AG2) de ligne menant à la cellule de mémoire, et une deuxième borne de canal de sélection de bloc étant reliée à la première borne de canal de transfert.

6. Mémoire à semi-conducteur suivant la revendication 5, **caractérisée en ce qu'**il est prévu un conducteur (BLKN) de contrôle de sélection de bloc, qui est relié aux bornes de grille de sélection de bloc de façon que les transistors (BT11, BT12) de sélection de bloc puissent être commandés par le conducteur (BLKN) de contrôle de sélection de bloc.
